# EUROPEAN PATENT APPLICATION

(11) **EP 4 254 477 A1**
(43) Date of publication of application: **04.10.2023**
(21) Application number: 21951581.4
(22) Date of filing: 20.10.2021
(51) Int. Cl.: H01L 21/768, H01L 23/538

(54) **THROUGH-SILICON VIA STRUCTURE, THROUGH-SILICON VIA INTERCONNECTION STRUCTURE AND PREPARATION METHOD, AND ELECTRONIC DEVICE**

(30) Priority: 26.07.2021 CN 202110844292
(71) Applicant: Tencent Technology (Shenzhen) Company Limited, Shenzhen, Guangdong, 518057 (CN); Gusu Laboratory of Materials, Suzhou, Jiangsu 215123 (CN)
(72) Inventor: ZHENG, Weiwen, Suzhou, Jiangsu 215123 (CN); XIONG, Kanglin, Suzhou, Jiangsu 215123 (CN); FENG, Jiagui, Suzhou, Jiangsu 215123 (CN); LI, Xiaowei, Suzhou, Jiangsu 215123 (CN); ZHANG, Wenlong, Shenzhen, Guangdong 518057 (CN); BU, Kunliang, Shenzhen, Guangdong 518057 (CN); LI, Dengfeng, Shenzhen, Guangdong 518057 (CN)
(74) Representative: Gunzelmann, Rainer
(86) International application number: PCT/CN2021/125095
(87) International publication number: WO 2023/005009

(57) **Abstract**

The present application discloses a through-silicon via structure, a through-silicon via interconnect structure and preparation method, and an electronic device, belonging to the technical field of semiconductors. The method comprises: forming a silicon oxide thin film on an inner wall of an initial via by means of oxidation processing after forming the initial via penetrating through a silicon-based substrate, then removing the silicon oxide thin film to obtain a through-silicon via structure having a through-silicon via. Because the inner wall of the initial via gradually tends to become smooth after being oxidized to form a silicon oxide film of a certain thickness, the inner wall of the through-silicon via of the through-silicon via structure formed by removing the silicon oxide film is relatively smooth, and thus a quality of a conductive material subsequently grown on the inner wall of the through-silicon via is not affected.

## Description

### RELATED APPLICATION

This application claims priority to Chinese Patent Application No. 202110844292.7, filed with the Chinese Patent Office on July 26, 2021 and entitled "THROUGH-SILICON VIA STRUCTURE, THROUGH-SILICON VIA INTERCONNECTION STRUCTURE AND PREPARATION METHOD, AND ELECTRONIC DEVICE ", which is incorporated herein by reference in its entirety.

### FIELD OF THE TECHNOLOGY

This application relates to the technical field of semiconductors, in particular, to a through-silicon-via structure and a method for preparing the same, a through-silicon-via interconnection structure and a method for preparing the same, and an electronic device.

### BACKGROUND OF THE DISCLOSURE

A Through-Silicon-Via (TSV) refers to a through hole extending through a silicon-based substrate of a chip, and an inner wall of the TSV is used for growing a conducting material to realize interconnection between chips.

In the related art, a Bosch process is generally used to repeatedly perform etching and passivation on a silicon-based substrate to form TSVs extending through the silicon-based substrate.

However, inner walls of the TSVs formed by the Bosch process are relatively rough, which affects the quality of conducting materials subsequently grown on the inner walls of the TSVs.

### SUMMARY

Embodiments of this application relate to a through-silicon-via structure and a method for preparing the same, a through-silicon-via interconnection structure and a method for preparing the same, and an electronic device, and the problem in the related technology that an inner wall of a through-silicon-via is relatively rough can be solved. The technical solutions are as follows:

In one aspect, a method for preparing a through-silicon-via structure is provided, the method including:
forming, on a silicon-based substrate, an initial through hole extending through the silicon-based substrate;
oxidizing an inner wall of the initial through hole to form a silicon oxide layer on the inner wall of the initial through hole; and
removing the silicon oxide layer to obtain a through-silicon-via structure with a through-silicon-via.

Optionally, the forming, on a silicon-based substrate, an initial through hole extending through the silicon-based substrate includes:
placing the silicon-based substrate on a supporting substrate;
etching the silicon-based substrate to form the initial through hole extending through the silicon-based substrate, an etching depth of the etching is greater than a thickness of the silicon-based substrate;
the method further includes: removing the supporting substrate.

Optionally, each of the silicon-based substrate and the supporting substrate has a polished surface, and the polished surface of the supporting substrate is in contact with the polished surface of the silicon-based substrate.

Optionally, the silicon-based substrate is a double-polished silicon-based substrate.

Optionally, the supporting substrate is a single-polished silicon-based substrate.

Optionally, the thickness of the silicon-based substrate is greater than or equal to 50 microns, and less than or equal to 300 microns.

Optionally, the thickness of the silicon oxide layer is greater than or equal to 10 nanometers, and less than or equal to 2000 nanometers.

Optionally, the oxidizing an inner wall of the initial through hole to form a silicon oxide layer on the inner wall of the initial through hole includes:
thermally oxidizing the inner wall of the initial through hole to form the silicon oxide layer on the inner wall of the initial through hole.

Optionally, a process adopted for thermal oxidization includes: a wet thermal oxidization process and/or a dry thermal oxidization process.

Optionally, the removing the silicon oxide layer to obtain a through-silicon-via structure with a through-silicon-via includes:
treating the initial through hole with the silicon oxide layer using a wet etching process to remove the silicon oxide layer to obtain the through-silicon-via structure with the through-silicon-via.

Optionally, an etch solution adopted in the wet etching process includes a Buffered Oxide Etch (BOE) solution.

Optionally, the silicon oxide layer is a silicon dioxide layer.

In another aspect, a through-silicon-via structure is provided, the through-silicon-via structure being prepared using the above method for preparing a through-silicon-via structure.
the through-silicon-via structure including: a silicon-based substrate, and a through-silicon-via extending through the silicon-based substrate.

In a further aspect, a method for preparing a through-silicon-via interconnection structure is provided, the method including:
preparing a through-silicon-via structure using the above method for preparing a through-silicon-via structure; and
forming a conducting material on an inner wall of a through-silicon-via of the through-silicon-via structure.

In yet another aspect, a through-silicon-via interconnection structure is provided, the through-silicon-via interconnection structure including: a through-silicon-via, and a conducting material formed on an inner wall of a through-silicon-via of the through-silicon-via structure;
the through-silicon-via structure being prepared using the above method for preparing a through-silicon-via structure.

According to yet another aspect, an electronic device is provided, the electronic device including: a first chip, a second chip, and the above through-silicon-via interconnection structure;
the first chip, the through-silicon-via interconnection structure and the second chip being stacked in sequence, and the first chip and the second chip being interconnected through the through-silicon-via interconnection structure.

The beneficial effects of the technical solutions provided by the embodiments of this application at least include:
a through-silicon-via structure and a method for preparing the same, a through-silicon-via interconnection structure and a method for preparing the same, and an electronic device. The method includes the steps of: after forming an initial through hole extending through a silicon-based substrate, first forming a silicon oxide layer on an inner wall of the initial through hole through oxidization, and then removing the silicon oxide layer to obtain a through-silicon-via structure with a through-silicon-via. The inner wall of the initial through hole will gradually tend to be smooth after being oxidized to form the silicon oxide layer with a certain thickness, so that the inner wall of the through-silicon-via of the through-silicon-via structure formed after the silicon oxide layer is removed is relatively smooth, which will not affect the quality of the conducting material subsequently grown on the inner wall of the through-silicon-via.

### BRIEF DESCRIPTION OF THE DRAWINGS

To describe the technical solutions in the embodiments of this application more clearly, the following briefly introduces the accompanying drawings required for describing the embodiments. Apparently, the accompanying drawings in the following description show merely some embodiments of this application, and a person of ordinary skill in the art may still derive other accompanying drawings from the accompanying drawings without creative efforts.
FIG. 1 is a schematic diagram of a silicon-based substrate with an undercut shape provided according to an implementation of the present disclosure;
FIG. 2 is a schematic diagram of a silicon-based substrate with a notch shape provided according to an implementation of the present disclosure;
FIG. 3 is a schematic diagram of a silicon-based substrate, an inner wall of a through-silicon-via is shaped like a "scallop", provided according to an implementation of the present disclosure;
FIG. 4 is a flowchart of a method for preparing a through-silicon-via structure provided according to an embodiment of the present disclosure;
FIG. 5 is a flowchart of a method for preparing another through-silicon-via structure provided according to an embodiment of the present disclosure;
FIG. 6 is a schematic diagram of an equivalent process for preparing a through-silicon-via structure provided according to an embodiment of the present disclosure;
FIG. 7 is a schematic diagram of an equivalent process for preparing a through-silicon-via structure provided according to an embodiment of the present disclosure;
FIG. 8 is a schematic structural diagram of a through-silicon-via structure provided according to an embodiment of the present disclosure;
FIG. 9 is a flowchart of a method for preparing a through-silicon-via interconnection structure provided according to an embodiment of the present disclosure;
FIG. 10 is a schematic structural diagram of a through-silicon-via interconnection structure provided according to an embodiment of the present disclosure; and
FIG. 11 is a schematic structural diagram of an electronic device according to an embodiment of the present disclosure.

Illustrations of all the numerals in the drawings are as follows:
10: through-silicon-via structure;
00: supporting substrate; 01: silicon-based substrate; 02: silicon oxide layer;
K0: initial through hole; K1: through-silicon-via; M1: conductive material;
100: through-silicon-via interconnection structure; 200: first chip; 300: second chip;
000- electronic device.

### DESCRIPTION OF EMBODIMENTS

To make the objectives, technical solutions, and advantages of this application clearer, the following further describes the implementations of this application in detail with reference to the accompanying drawings.

For ease of understanding, before describing the technical solutions of the embodiments of this application, the following explains terms in the embodiments of this application:
Through-Silicon-Via (TSV) technology: The technology is to make vertical conduction (i.e., a through-silicon-via interconnection structure in the following embodiments) between chips or between wafers to realize interconnection of a plurality of layers of stacked chips. The various layers of chips are interconnected through the TSV technology, so that the chips have a large stacking density and a small size in a three-dimensional direction. Furthermore, the data transmission speed in the chips can also be greatly improved, and the power consumption of the chips can be reduced.

Interposer: It is a chip with a through-silicon-via structure, that is, a through-silicon-via interconnection structure. The through-silicon-via structure includes a silicon-based substrate, and a through-silicon-via extending through the silicon-based substrate. In a process of stacking and packaging multiple layers of chips, the interposer may be used to interconnect the multiple chips on different layers above and below, so as to achieve integration of the chips with different functions. In this way, the operation interaction of many data can be achieved. Exemplarily, assuming that there are three chips stacked in sequence, the chip at the middle position may be used as an interposer to connect the chip on an upper layer to the chip on a lower layer. The upper layer and the lower layer are relative to the middle position.

Undercut: It is an abnormal shape at an opening of a through-silicon-via due to etching. For example, at present, a silicon-based substrate is first generally placed on a tray coated with a thermally conductive adhesive, and is then etched by a physical etching method in which accelerated bombardment is downwards performed by positively charged particles, so as to form a through-silicon-via extending through the silicon-based substrate. However, when the silicon-based substrate is etched through, the thermally conductive adhesive will be sprayed into the through-silicon-via under the bombardment of the positively charged particles. At this time, the bottom of the silicon-based substrate cannot be etched effectively. As a result, an abnormal shape of a downward protrusion is formed at the bottom of the finally etched through-silicon-via. This abnormal shape may be referred to as an undercut shape. The bottom is relative to the top. The bottom may also be referred to as a lower surface of the silicon-based substrate, and the top may also be referred to as an upper surface of the silicon-based substrate. During forming of the through-silicon-via extending through the silicon-based substrate, the silicon-based substrate is generally etched along a direction from the upper surface of the silicon-based substrate to the lower surface of the silicon-based substrate.

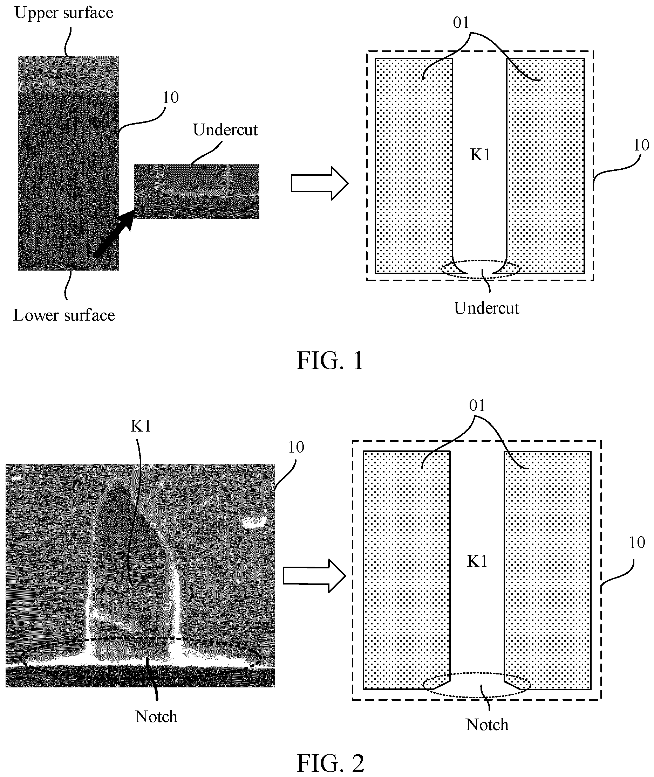

Exemplarily, FIG. 1 schematically shows a schematic structural diagram of a through-silicon-via structure. It can be seen from FIG. 1 that in the through-silicon-via structure 10, a through-silicon-via K1 extending through a through-silicon-via substrate 01 has an undercut shape. The left side shows an actual structural diagram of the through-silicon-via structure 10, and the right side shows an equivalent diagram of the diagram on the left.

Notch: It is another abnormal shape at an opening of a through-silicon-via due to etching. For example, at present, a silicon-based substrate is first generally placed on a tray of an etching device, and is then etched by a physical etching method in which accelerated bombardment is downwards performed by positively charged particles. However, due to the impact of a material of the tray, after the silicon-based substrate is etched through, the silicon-based substrate usually may not be continuously downwards etched, and at this time, the positively charged particles are gathered at the bottom of the silicon-based substrate cannot be effectively removed. Subsequently inrush positively charged particles will continually etch edges of the bottom of the silicon-based substrate, thereby forming a notch.

Exemplarily, FIG. 2 schematically shows a schematic structural diagram of a through-silicon-via structure. It can be seen from FIG. 2 that in the through-silicon-via structure 10, a through-silicon-via K1 extending through a through-silicon-via substrate 01 has a notch. The left side shows an actual structural diagram of the through-silicon-via structure 10, and the right side shows an equivalent diagram of the diagram on the left.

"Scallop" shape: Under the impact of the principle of the Bosch process, an inner wall of the through-silicon-via obtained by etching the silicon-based substrate is generally rough and rugged. This is referred to as a "scallop" shape because it is like a scallop. The "scallop" shape will affect the quality of a conducting material subsequently filling the through-silicon-via, and further, will increase the loss of signals transmitted via the through-silicon-via and reduce the overall performance of a chip.

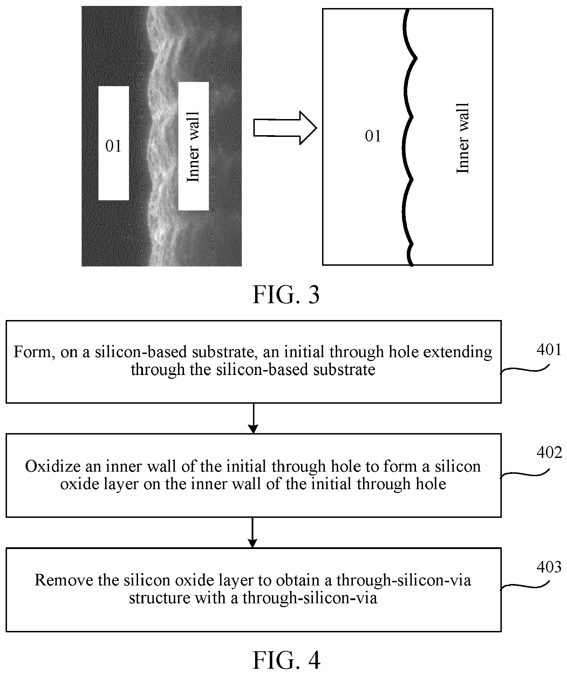

Exemplarily, FIG. 3 schematically shows a silicon-based substrate 01 having a "scallop"-shaped through-silicon-via K1. The left side shows a sectional view of an actual structure of the silicon-based substrate 01, and the right side shows an equivalent diagram of the diagram on the left. It can be seen from FIG. 3 that the inner wall of the through-silicon-via is uneven.

3D packaging: It is a packaging method that stacks a plurality of chips and interconnects the chips through through-silicon-via structures of the chips, thereby reducing the overall volume, improving the overall performance, and reducing power consumption. The multiple stacked chips may have different functions.

An embodiment of this application provides a method for preparing a through-silicon-via structure. An inner wall of a through-silicon-via of the through-silicon-via structure obtained by the method is not only smooth, but also vertical, that is, it does not have abnormal shapes such as undercuts and notches. In this way, the quality of a conducting material subsequently grown on the inner wall of the through-silicon-via will not be affected.

FIG. 4 is a flowchart of a method for preparing a through-silicon-via structure provided according to an embodiment of this application. As shown in FIG. 4, the method includes the following steps:
Step 401. Form, on a silicon-based substrate, an initial through hole extending through the silicon-based substrate.

First, the silicon (Si)-based substrate may be etched using an etching process to form a through hole extending through the silicon-based substrate. The through hole may be referred to as the initial through hole.

Step 402. Oxidize an inner wall of the initial through hole to form a silicon oxide layer on the inner wall of the initial through hole. The silicon oxide layer, for example, may be a silicon oxide thin film.

Second, an inner wall of the initial through hole may be thermally oxidized using a thermal oxidization process, so as to form a silicon oxide layer on the inner wall of the initial through hole.

Step 403. Remove the silicon oxide layer to obtain a through-silicon-via structure with a through-silicon-via.

Finally, the silicon oxide layer with a certain thickness may be formed on the inner wall of the initial through hole; after the inner wall of the initial through hole is made to be smooth, the silicon oxide layer formed on the inner wall of the initial through hole is removed using an etching process, thus obtaining a through-silicon-via with a smooth inner wall. That is, the inner wall of the through-silicon-via of the finally obtained through-silicon-via structure is smooth.

To sum up, an embodiment of this application provides a method for preparing a through-silicon-via structure. The method includes the steps of: after forming an initial through hole extending through a silicon-based substrate, first forming a silicon oxide layer on an inner wall of the initial through hole through oxidization, and then removing the silicon oxide layer to obtain a through-silicon-via structure with a through-silicon-via. The inner wall of the initial through hole will gradually tend to be smooth after being oxidized to form the silicon oxide layer with a certain thickness, so that the inner wall of the through-silicon-via of the through-silicon-via structure formed after the silicon oxide layer is removed is relatively smooth, which will not affect the quality of the conducting material subsequently grown on the inner wall of the through-silicon-via.

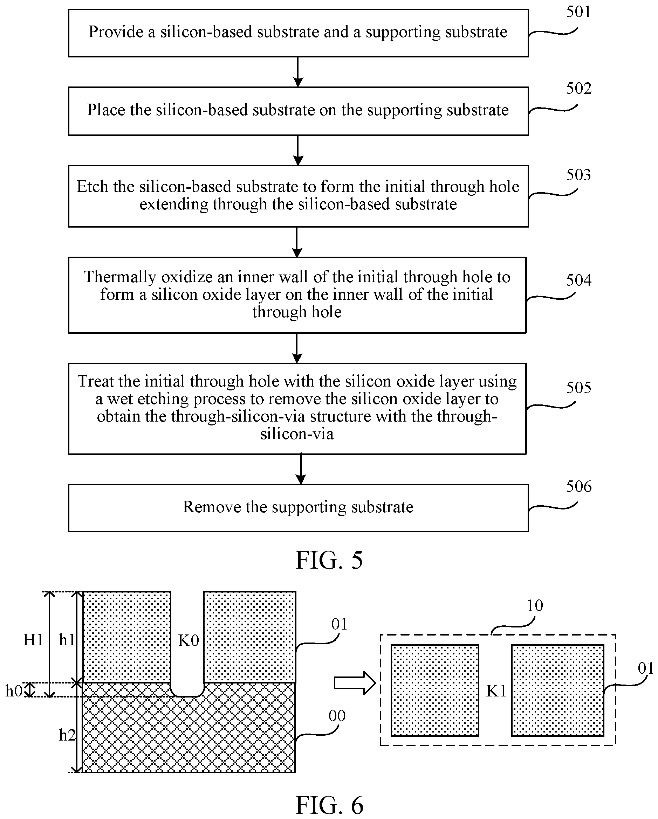

FIG. 5 is a flow chart of another method for preparing a through-silicon-via structure provided according to an embodiment of this application. As shown in FIG. 5, the method may include the following steps:
Step 501. Provide a silicon-based substrate and a supporting substrate.

FIG. 6 shows a schematic structural diagram of a silicon-based substrate 01 and a supporting substrate 00 provided.

Optionally, with reference to FIG. 6, the thickness h1 of the silicon-based substrate 01 in this embodiment of this application may be greater than or equal to 50 micrometers (µm) and less than or equal to 300 µm. For example, the thickness may be 200 µm. By providing the silicon-based substrate 01 that meets the thickness requirement, a through-silicon-via with a larger depth is convenient to prepare. It is referred to as a deep hole.

Optionally, the silicon-based substrate may generally include: a double-polished silicon-based substrate and a single-polished silicon-based substrate. The double-polished silicon-based substrate refers to a silicon-based substrate whose upper surface and lower surface have been polished. That is, the double-polished silicon-based substrate is a silicon-based substrate with two polished surfaces. The single-polished silicon-based substrate refers to a silicon-based substrate. only one of an upper surface and a lower surface of which has been polished. That is, the single-polished silicon-based substrate is a silicon-based substrate with a single polished surface.

In general, a conducting material needs to be formed on the polished surface, so if a through-silicon-via is fabricated on the single-polished silicon-based substrate, after the through-silicon-via is obtained, it is also necessary to perform subsequent thinning polishing treatment on the unpolished surface (which is generally the lower surface) of the single-polished silicon-based substrate with the through-silicon-via. The process is relatively complicated, and the efficiency is relatively low. Therefore, in this embodiment of this application, the silicon-based substrate 01 provided may be a double-polished silicon-based substrate, so as to effectively simplify the process and improve the preparation efficiency. Of course, in some embodiments, the silicon-based substrate 01 provided may also be a single-polished silicon-based substrate. The following embodiments are all described by taking a double-polished silicon-based substrate being the silicon-based substrate 01 as an example.

Optionally, the supporting substrate 00 may be a conventional single-polished silicon-based substrate since it only provides a supporting function. Of course, in some embodiments, the supporting substrate 00 may also be a double-polished silicon-based substrate. The following embodiments are all described by taking a single-polished silicon-based substrate being the supporting substrate 00 as an example.

Step 502. Place the silicon-based substrate on a supporting substrate.

Continuing with reference to FIG. 6, it can be seen that the silicon-based substrate 01 may be placed above the supporting substrate 00. Referring to the above embodiments, it can be known that each of the silicon-based substrate 01 and the supporting substrate 00 has a polished surface. In this embodiment of this application, the polished surface of the supporting substrate 00 may be set to be in contact with the polished surface of the silicon-based substrate 01.

For example, if the supporting substrate 00 is a single-polished silicon-based substrate, and the silicon-based substrate 01 is a double-polished silicon-based substrate, the double-polished silicon-based substrate 01 may be placed on the polished surface of the single-polished silicon-based substrate. That is, one polished surface of the double-polished silicon-based substrate 01 is in contact with the polished surface of the single-polished silicon-based substrate. In this way, the double-polished silicon-based substrate 01 and the single-polished silicon-based substrate can be reliably adsorbed and fixed by virtue of their own interatomic forces, and will not cause damage to their polished surfaces. Of course, in some embodiments, the unpolished surface of the supporting substrate 00 may also be set to be in contact with any surface of the silicon-based substrate 01. For example, the double-polished silicon-based substrate 01 may be placed on the unpolished surface of the single-polished silicon-based substrate.

Optionally, before the double-polished silicon-based substrate on the supporting substrate 00, the two mutually contacting surfaces of the double-polished silicon-based substrate and the supporting substrate 00 may be first cleaned respectively. In this way, the firmness of adsorption between the double-polished silicon-based substrate and the supporting substrate 00 can be improved. For example, referring to FIG. 6, the two mutually contacting surfaces of the double-polished silicon-based substrate and the supporting substrate 00 may be respectively: the lower surface of the double-polished silicon-based substrate 01, and the upper surface of the supporting substrate 00.

Step 503. Etch the silicon-based substrate to form the initial through hole extending through the silicon-based substrate.

Optionally, the silicon-based substrate may be etched by an etching device. Generally, the etching device is provided with a tray. After the silicon-based substrate is placed on the supporting substrate, the supporting substrate may be placed on the tray first, that is, the silicon-based substrate is not in contact with the tray; and the silicon-based substrate is then etched to form the initial through hole extending through the silicon-based substrate.

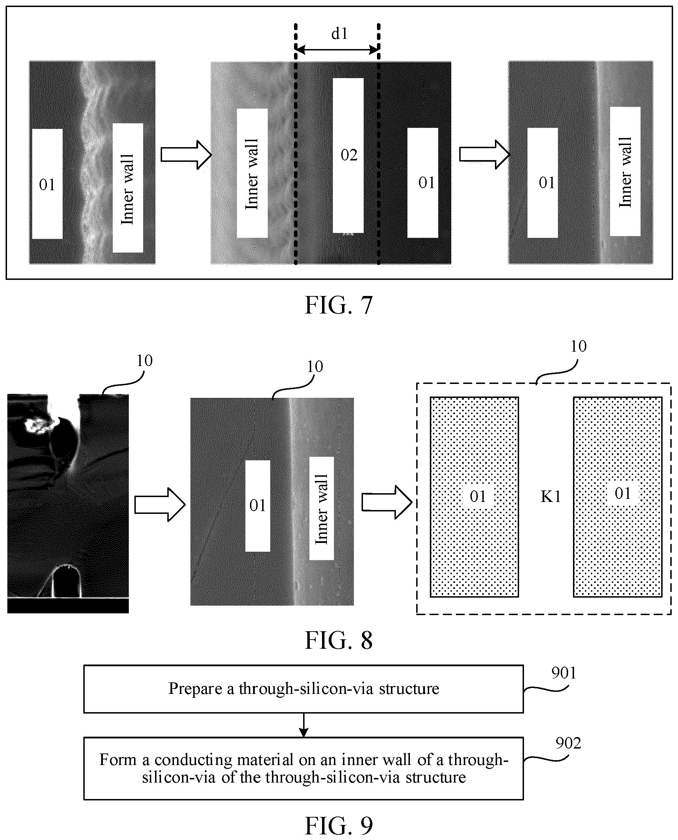

Optionally, an etching process may use a Bosch process. It can be seen that the inner wall of the initial through hole formed at this time is generally in the "scallop" shape as shown in the left drawings in FIG. 3 and FIG. 7, that is, the surface of the inner wall of the initial through hole is rough, and is provided with a recess and a bulge. Of course, in some embodiments, other etching processes, such as physical etching or chemical etching, may also be used.

In addition, during the etching of the silicon-based substrate, first, a desired etching pattern may be defined on a surface (i.e. the upper surface) of one side of the silicon-based substrate away from the supporting substrate by a photolithography process, and this pattern is an opening position of the initial through hole obtained by etching. An etching device may be used to etch downward from the position of the pattern until the silicon-based substrate is etched through. This pattern may be a circle, the size ϕ (i.e. a diameter) of which may be about 10 µm. Of course, in some embodiments, the pattern may also be in other shapes, such as a rectangle, the size of which may also be other sizes. It is noted that in order to avoid mis-etching in other places, photoresist may be attached at positions that do not need to be etched on the upper surface of the silicon-based substrate. Correspondingly, the photoresist needs to be removed after the initial through hole is obtained by etching.

Optionally, the way to remove the photoresist may be: first putting the silicon-based substrate with the initial through hole into an acetone cleaning solution for ultrasonic cleaning for 10 min; then putting the silicon-based substrate cleaned with the acetone cleaning solution into an isopropanol cleaning solution for ultrasonic cleaning for 10 min; putting the silicon-based substrate cleaned with the isoacetone cleaning solution into deionized (DI) water for ultrasonic cleaning for 10 min; and finally blowing the cleaned silicon-based substrate to dry with a nitrogen (N2) gun. Moreover, in all the steps involving the ultrasonic cleaning described in this embodiment of this application, the power of ultrasonic cleaning may be greater than or equal to 50 W and less than or equal to 800 W.

It is noted that the cleaning duration is not limited in this embodiment of this application, as long as it ensures that the coated photoresist can be cleaned finally.

Optionally, referring to FIG. 6, in this embodiment of this application, an etching thickness H1 of the etching treatment on the silicon-based substrate 01 may be greater than h1 of the silicon-based substrate. That is, the supporting substrate 00 arranged on one side of the lower surface of the silicon-based substrate 01 is over-etched while the silicon-based substrate 01 is etched. Generally, it is not necessary to etch through the supporting substrate 00, so that the process can be simplified. Of course, in some embodiments, the supporting substrate 00 may also be etched through. In other words, the duration of etching the silicon-based substrate 01 may be a total duration for which the etching thickness H1 can reach h1+h0. h0 may refer to an overetching thickness of the supporting substrate 00. h0 is greater than 0 and less than or equal to h2, and h2 refers to the thickness of the supporting substrate 00.

For example, referring to FIG. 6, assuming that the thickness h2 of the supporting substrate 00 is 100 µm, the over-etching thickness h0 of the supporting substrate 00 may be greater than or equal to 10 µm and less than or equal to 100 µm. Assuming that the thickness h1 of the silicon-based substrate 01 is 200 µm, and the overetching thickness h0 of the supporting substrate 00 is 30 µm, it can be determined that the etching thickness H1 of the silicon-based substrate 01 is 230 µm, which is greater than the thickness h1=200 µm of the silicon-based substrate 01, thus achieving slight etching of the supporting substrate 00. Furthermore, in this size, a test shows that in the inner wall of the initial through hole K0 obtained by etching, a distance between every two adjacent recess and protrusion is about 60 nanometers (nm). A direction of the distance is parallel to an extending direction of the initial through hole K0.

Step 504. Thermally oxidize the inner wall of the initial through hole to form a silicon oxide layer on the inner wall of the initial through hole.

Optionally, the thermal oxidation process used in the thermal oxidation treatment may include: a wet thermal oxidization process and/or a dry thermal oxidization process. That is, the inner wall of the initial through hole may be thermally oxidized using a wet thermal oxidization process and/or the dry thermal oxidization process, so as to form a silicon oxide layer on the inner wall of the initial through hole.

Oxidizing gas used in the wet thermal oxidation process generally includes hydrogen (H2) and oxygen (O2), and oxidizing gas used in the dry thermal oxidation process generally includes O2 only. As such, the formed silicon oxide layer is a silicon dioxide film. When it is necessary to thermally oxide the inner wall of the initial through hole, the silicon-based substrate 01 with the initial through hole may be put into a thermal oxidization device (such as a thermal oxidation furnace) and heated. When the silicon-based substrate is heated to a target temperature, the desired oxidizing gas is introduced. For example, the target temperature may be greater than or equal to 1000°C and less than or equal to 1200°C.

Optionally, if the initial through hole only runs through the silicon-based substrate 01, the silicon-based substrate 01 may be removed from the supporting substrate 00 and placed into the thermal oxidation device. If the initial through hole runs through both the silicon-based substrate 01 and part of the supporting substrate 00, the silicon-based substrate 01 may be removed from the supporting substrate 00 and placed in the thermal oxidation device, or, the silicon-based substrate 01 and the supporting substrate 00 are put into the thermal oxidation device as a whole.

Optionally, if the wet thermal oxidation process and the dry thermal oxidation process are used to thermally oxidize the inner wall of the initial through hole, the wet thermal oxidation process may be used to thermally oxidize the inner wall of the initial through hole first, and the dry thermal oxidation process is then used to thermally oxidize the inner wall of the initial through hole.

Optionally, referring to FIG. 7, the thickness d1 of the formed silicon oxide layer 02 may be greater than or equal to 10 nm and less than or equal to 2000 nm. After the test, when the inner wall of the initial through hole reacts under the thermal oxidation to form the silicon oxide layer with a certain thickness, that is, when the silicon oxide layer 02 grows to a certain thickness, the silicon oxide layer and the inner wall of the initial through hole will naturally form a smooth and straight interface. In other words, the inner wall of the initial through hole becomes smooth.

As an example, assuming that the target temperature is 1200°C, and only the wet thermal oxidization process is used to thermally oxidize the inner wall of the initial through hole, the silicon-based substrate 01 with the initial through hole may be put into the thermal oxidation furnace; and when the temperature in the furnace reaches 1200°C, O2 with a flow rate of 8 slpm is first introduced for 60 min. After the O2 is introduced for 10 min, H2 with a flow rate of 14 slpm may be started to be introduced for 34 min. The thermal oxidation furnace is turned off, and the silicon-based substrate 01 is taken out after the temperature in the furnace is lowered to room temperature. After the test, after the silicon-based substrate 01 is thermally oxidized under this condition, the thickness d1 of the formed silicon oxide layer can reach 500 nm, which meets the above-mentioned thickness requirement, wherein slpm refers to a liter value per minute in a standard state, which is used for defining the size of a flow rate.

It is noted that this embodiment of this application does not limit the flow rate of the introduced gas and the duration of introducing the gas, as long as the flow rate and the duration can ensure that the silicon oxide layer with the required thickness can be finally formed to make the inner wall of the initial through hole smooth.

Step 505. The initial through hole with the silicon oxide layer is treated using a wet etching process to remove the silicon oxide layer to obtain the through-silicon-via structure with the through-silicon-via.

The wet etching process refers to a process in which an object to be etched needs to be placed in an etch solution for ultrasonic cleaning. The cleaning duration, cleaning temperature (i.e. the temperature of the etch solution) and cleaning power can be flexibly set on the basis of the thickness of the object to be etched, so as to ensure that the object to be etched is etched cleanly.

Optionally, in this embodiment of this application, the etch solution for etching the initial through hole formed with the silicon oxide layer may include a Buffered Oxide Etch (BOE) solution. Based on the thickness requirement of the silicon oxide layer defined in the above embodiment, it can be known that in this embodiment of this application, the cleaning duration for cleaning the initial through hole formed with the silicon oxide layer using the BOE solution may be greater than or equal to 10 s, and less than or equal to 3600 s. The cleaning temperature may be greater than or equal to 20°C and less than or equal to 80°C.

The BOE solution refers to a solution formed by mixing hydrofluoric acid (HF) and ammonium fluoride (NH4F) in a certain proportion. The HF is the main etch solution, and NH4F is used as a buffer.

Optionally, in this embodiment of this application, the BOE solution may include 40% of NH4F and 9% of HF. A ratio of 40% NH4F to 9% HF may be greater than or equal to 7:1 and less than or equal to 20:1.

Exemplarily, the silicon-based substrate 01 after the thermal oxidation treatment in step 504 may be completely immersed in the BOE solution with a temperature of 40°C, in which a ratio of 40% NH4F to 9% HF is 7:1., for ultrasonic cleaning for 10 min, thereby obtaining the through-silicon-via structure 10 shown on the right side of FIG. 6 and the farthest to the right of FIG. 7. It can be seen by referring to FIG. 7 that after the wet etching process, the silicon oxide layer 02 formed on the inner wall of the initial through hole K0 disappears, and only the silicon-based substrate 01 with the through hole K0 with the smooth inner wall remains. If the supporting substrate 00 has been removed at this time, the obtained structure is the desired through-silicon-via structure in this embodiment of this application.

In addition, after the wet etching process, the silicon-based substrate 01 with the through-silicon-via may also be placed in DI water with a temperature of 40°C for further ultrasonic cleaning for 10 min, and is then blown to dry with an N2 gun.

It is noted that in all cleaning operations involved in this embodiment of this application, when the entire silicon-based substrate 01 can immersed into the cleaning solution, the opening of the initial through hole is set upward, and an included angle between the upper surface of the silicon-based substrate 01 and a horizontal plane of the cleaning solution may be greater than or equal to 0 degrees and less than or equal to 90 degrees. For example, the included angle may be 45 degrees. In this way, the solution is easily poured into the initial through hole.

Step 506. Remove the supporting substrate.

Optionally, in this embodiment of this application, after the initial through hole is obtained by etching, that is, after step 503 is carried out, the supporting substrate 00 may be removed from one side of the silicon-based substrate 01. In other words, the subsequent steps 504 and 505 are only executed to treat the silicon-based substrate 01.

Of course, in some embodiments, the supporting substrate 00 may also be removed after step 504, that is, after the silicon-based substrate 01 is thermally oxidized to form the silicon oxide layer. Or, the supporting substrate 00 may also be removed after step 505, that is, after the silicon-based substrate 01 is wet etched to form the silicon oxide layer.

After the test, if the silicon-based substrate 01 is directly placed on a tray of an etching device for etching, the lower surface (i.e. the bottom) of the through-silicon-via of the finally obtained through-silicon-via structure easily has a notch as shown in FIG. 2 under the impact of the material of the tray. Or, if the silicon-based substrate 01 is directly placed on a tray coated with a thermally conductive adhesive for etching, the bottom of the through-silicon-via of the finally obtained through-silicon-via structure is easily has an undercut as shown in FIG. 3 under the impact of the etching process and a material of the thermally conductive adhesive. Both a notch and an undercut will cause the through-silicon-via of the finally formed through-silicon-via structure to be not vertical.

In this embodiment of this application, since the supporting substrate 00 is provided to support the silicon-based substrate 01, that is, since the silicon-based substrate 01 is not in direct contact with the tray of the etching device, and is not in direct contact with the tray coated with the thermally conductive adhesive, the notch problem shown in FIG. 2 and the undercut problem shown in FIG. 3 in the finally obtained through-silicon-via can be effectively avoided. Furthermore, it can be determined that the through-silicon-via manufactured by the method provided in this embodiment of this application is relatively vertical.

Exemplarily, referring to the through-silicon-via structure 10 shown on the right side of FIG. 6 and the through-silicon-via structure 10 shown in FIG. 8, it can be known that after the above steps 501 to 505 are performed and the supporting substrate 00 is removed, the through-silicon-via structure with the smooth inner wall and the vertical through-silicon-via K1 can be obtained. FIG. 8 shows, from left to right, a schematic diagram of an actual product of the through-silicon-via structure 10 with the through-silicon-via K1, an internal cross-sectional view of the actual product of the through-silicon-via structure 10, and an equivalent diagram of the actual product of the through-silicon-via structure 10.

It can be seen from the above embodiments that on the one hand, in this embodiment of this application, the inner wall of the through-silicon-via of the finally obtained through-silicon-via structure can be smooth by means of combining thermal oxidation with wet etching. On the other hand, by means of providing the supporting substrate and placing the silicon-based substrate on the supporting substrate for etching to obtain the through-silicon-via, the through-silicon-via of the finally obtained through-silicon-via structure is vertical, so that the undercut or notch phenomenon at the bottom of the through-silicon-via is eliminated. The vertical and smooth topography is not only conducive to the growth of the conducting material, but also can effectively improve the signal-to-noise ratio of microwave signals (a type of a signal transmitted by a chip) in qubits and can ensure that the structures of conductive patterns formed on the upper and lower surfaces of the silicon-based substrate are intact.

It is also noted that the order of the steps of the method for preparing the through-silicon-via structure provided by this embodiment of this application can be adjusted appropriately, and the steps can also be increased or decreased according to a situation. For example, step 506 can be performed before step 504. That is, a silicon oxide layer can be formed before the supporting substrate is removed. Any variation or replacement readily figured out by a person skilled in the art within the technical scope disclosed in the present invention shall fall within the protection scope of the present. No repeated description is provided.

To sum up, an embodiment of this application provides a method for preparing a through-silicon-via structure. The method includes the steps of: after forming an initial through hole extending through a silicon-based substrate, first forming a silicon oxide layer on an inner wall of the initial through hole through oxidization, and then removing the silicon oxide layer to obtain a through-silicon-via structure with a through-silicon-via. The inner wall of the initial through hole will gradually tend to be smooth after being oxidized to form the silicon oxide layer with a certain thickness, so that the inner wall of the through-silicon-via of the through-silicon-via structure formed after the silicon oxide layer is removed is relatively smooth, which will not affect the quality of the conducting material subsequently grown on the inner wall of the through-silicon-via.

According to the schematic diagram of a through-silicon-via structure provided by this embodiment of this application, the through-silicon-via structure may be prepared using the method for preparing a through-silicon-via structure as shown in FIG. 4 or FIG. 5.

It can be seen by referring to FIG. 8 that the through-silicon-via structure 10 may include: a silicon-based substrate 01, and a through-silicon-via K1 extending through the silicon-based substrate 01.

FIG. 9 is a flow chart of a method for preparing a through-silicon-via interconnection structure provided according to an embodiment of this application. As shown in FIG. 9, the method may include the following steps:

Step 901. Prepare a through-silicon-via structure.

The through-silicon-via structure may be prepared using the above method for preparing a through-silicon-via structure as shown in FIG. 4 or FIG. 5. As such, in combination with the above embodiments, the inner wall of a through-silicon-via of the obtained through-silicon-via structure may be smooth, and the through-silicon-via is relatively vertical.

Step 902. Form a conducting material on the inner wall of the through-silicon-via of the through-silicon-via structure.

Optionally, the conducting material may be formed on the inner wall of the through-silicon-via of the through-silicon-via structure using a coating process. For the inner wall of the through-silicon-via, it may mean that the conducting material is grown on the inner wall of the through-silicon-via.

Optionally, the conducting material may be a superconducting material capable of conducting electricity, such as titanium nitride (TiN). The conducting material may be used for electrically connecting conductive patterns formed on the upper and lower surfaces of the silicon-based substrate, or to electrically connecting two chips placed on the upper and lower surfaces of the silicon-based substrate. That is, interconnection of different stacked chips is achieved.

Optionally, the through-silicon-via interconnection structure may be a chip, that is, a silicon-based substrate included in the chip may be etched to form a through-silicon-via to connect other chips located on two sides of the upper and lower surfaces of the chip.

To sum up, this embodiment of this application provides a method for preparing a through-silicon-via interconnection structure. In the method, during the preparation of the through-silicon-via structure, after an initial through hole extending through a silicon-based substrate is formed, a silicon oxide layer is first formed on an inner wall of the initial through hole through oxidization, and then the silicon oxide layer is removed to obtain a through-silicon-via structure with a through-silicon-via. Therefore, the inner wall of the through-silicon-via of the formed through-silicon-via structure is relatively smooth. Furthermore, the quality of the conducting material subsequently grown on the inner wall of the through-silicon-via will not be affected. Correspondingly, the through the through-silicon-via interconnection structure, namely the interconnection chip, prepared by the method has good reliability.

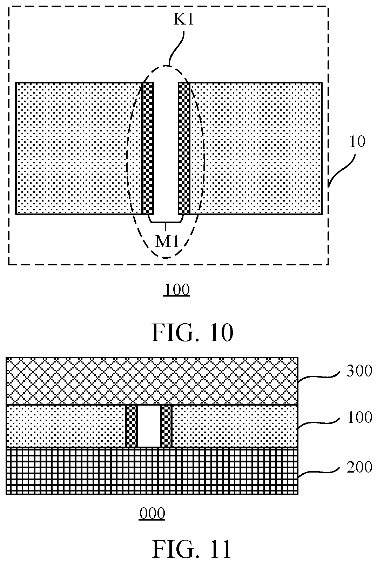

FIG. 10 is a schematic structural diagram of a through-silicon-via interconnection structure provided according to an embodiment of this application. As shown in FIG. 10, the through-silicon-via interconnection structure 100 may include: a through-silicon-via structure 10, a conducting material M1 formed (i.e. grown) on an inner wall of a through-silicon-via K1 of the through-silicon-via structure 10.

The through-silicon-via structure 10 can be prepared using the method for preparing a through-silicon-via structure as shown in FIG. 4 or FIG. 5. Correspondingly, with reference to the foregoing embodiments, it can be known that the through-silicon-via K1 of the through-silicon-via structure 10 included in the through-silicon-via interconnection structure 100 may be vertical and have a smooth inner wall.

FIG. 11 is a schematic structural diagram of an electronic device according to an embodiment of this application. As shown in FIG. 11, the electronic device 000 may include: a first chip 200, a second chip 300, and the through-silicon-via interconnection structure 100 shown in FIG. 10.

The first chip 200, the through-silicon-via interconnection structure 100 and the second chip 300 may be stacked in sequence, and the first chip 200 and the second chip 300 may be interconnected (i.e. connected to each other for conduction) through the through-silicon-via interconnection structure 100. Optionally, the through-silicon-via interconnection structure 100 may also be a chip, and is interconnected with the first chip 100 and the second chip 300 respectively. That is, the three chips may be stacked and are interconnected through the chip with a through-silicon-via structure in the middle.

It is noted that FIG. 11 only schematically shows the three layers of stacked structures. The electronic device may also include a larger number (e.g. five) of chips stacked in sequence, and the multiple chips may be interconnected through the through-silicon-via interconnection structure. Optionally, the electronic device may be a mobile terminal, such as a mobile phone or a tablet computer.

Optionally, the "first", the "second", the "third" and similar terms used in the embodiments of the present disclosure do not indicate any order, quantity or significance, but are used to only distinguish different components.

Similarly, "one", "a", and similar terms also do not indicate a quantity limitation, but indicates that there is at least one.

"comprising" or "containing" and similar terms mean that the elements or articles appearing before "comprising" or "containing" cover the listed elements or articles appearing after "comprising" or "containing" and equivalents thereof, and do not exclude other elements or articles.

"Connection", "connected", and similar terms are not limited to a physical or mechanical connection, but may include an electrical connection, regardless of a direct or indirect connection.

"Up", "down", "left", "right", and the like are merely used for indicating relative positional relationships. After absolute positions of described objects change, relative positional relationships may also change.

"And/or" represents that three relationships may exist. For example, A and/or B may represent: only A exists, both A and B exist, and only B exists. The character "/" generally indicates an "or" relationship between the associated objects.

The foregoing descriptions are merely optional embodiments of this application, but are not intended to limit this application. Any modification, equivalent replacement, or improvement made within the spirit and principle of this application shall fall within the protection scope of this application.

## Claims

1. A method for preparing a through-silicon-via structure, the method comprising:
forming, on a silicon-based substrate, an initial through hole extending through the silicon-based substrate;
oxidizing an inner wall of the initial through hole to form a silicon oxide layer on the inner wall of the initial through hole; and
removing the silicon oxide layer to obtain a through-silicon-via structure with a through-silicon-via.

2. The method according to claim 1, wherein the forming, on the silicon-based substrate, the initial through hole extending through the silicon-based substrate comprises:
placing the silicon-based substrate on a supporting substrate;
etching the silicon-based substrate to form the initial through hole extending through the silicon-based substrate, an etching depth of the etching is greater than a thickness of the silicon-based substrate;
the method further comprises: removing the supporting substrate.

3. The method according to claim 2, wherein each of the silicon-based substrate and the supporting substrate has a polished surface, and the polished surface of the supporting substrate is in contact with the polished surface of the silicon-based substrate.

4. The method according to any one of claims 1 to 3, wherein the silicon-based substrate is a double-polished silicon-based substrate.

5. The method according to any one of claims 1 to 3, wherein the supporting substrate is a single-polished silicon-based substrate.

6. The method according to any one of claims 1 to 3, wherein the thickness of the silicon-based substrate is greater than or equal to 50 microns, and less than or equal to 300 microns.

7. The method according to any one of claims 1 to 3, wherein the thickness of the silicon oxide layer is greater than or equal to 10 nanometers, and less than or equal to 2000 nanometers.

8. The method according to any one of claims 1 to 3, wherein the oxidizing the inner wall of the initial through hole to form the silicon oxide layer on the inner wall of the initial through hole comprises:
thermally oxidizing the inner wall of the initial through hole to form the silicon oxide layer on the inner wall of the initial through hole.

9. The method according to claim 8, wherein a process adopted for thermal oxidization comprises: a wet thermal oxidization process and/or a dry thermal oxidization process.

10. The method according to any one of claims 1 to 3, wherein the removing the silicon oxide layer to obtain the through-silicon-via structure with the through-silicon-via comprises:
treating the initial through hole with the silicon oxide layer using a wet etching process to remove the silicon oxide layer to obtain the through-silicon-via structure with the through-silicon-via.

11. The method according to claim 10, wherein an etch solution adopted in the wet etching process comprises a Buffered Oxide Etch (BOE) solution.

12. The method according to any one of claims 1 to 3, wherein the silicon oxide layer is a silicon dioxide layer.

13. A through-silicon-via structure, the through-silicon-via structure being prepared using the method for preparing a through-silicon-via structure according to any one of claims 1 to 12;
the through-silicon-via structure comprising: a silicon-based substrate, and a through-silicon-via extending through the silicon-based substrate.

14. A method for preparing a through-silicon-via interconnection structure, the method comprising:
preparing a through-silicon-via structure using the method for preparing a through-silicon-via structure according to any one of claims 1 to 12; and
forming a conducting material on an inner wall of a through-silicon-via of the through-silicon-via structure.

15. A through-silicon-via interconnection structure, the through-silicon-via interconnection structure comprising: a through-silicon-via, and a conducting material formed on an inner wall of a through-silicon-via of the through-silicon-via structure;
the through-silicon-via structure being prepared using the method for preparing a through-silicon-via structure according to any one of claims 1 to 12.

16. An electronic device, the electronic device comprising: a first chip, a second chip, and the through-silicon-via interconnection structure according to claim 15;
the first chip, the through-silicon-via interconnection structure and the second chip being stacked in sequence, and the first chip and the second chip being interconnected through the through-silicon-via interconnection structure.
